# FASCICULE DE BREVET EUROPEEN

(11) **EP 1 737 092 B1**
(45) Date de publication et mention de la délivrance du brevet: **01.04.2009**
(21) Numéro de dépôt: 06354017.3
(22) Date de dépôt: 02.06.2006
(51) Int. Cl.: H05K 1/02

(54) **Bus de communication et tableau electrique comportant un tel bus**
Kommunikationsbus und elektrische Schalttafel, die einen solchen Bus umfasst
Communication bus and electrical switchboard comprising said bus

(30) Priorité: 24.06.2005 FR 0506459
(43) Date de publication de la demande: 27.12.2006
(73) Titulaire: Schneider Electric Industries SAS, 92500 Rueil-Malmaison (FR)
(72) Inventeur: Conil, Jean-Pierre, Schneider Electric Ind. SAS, 38050 Grenoble Cedex 09 (FR); Cruchet, Victor, Schneider Electric Ind. SAS, 38050 Grenoble Cedex 09 (FR); Linares, Louis, Schneider Electric Ind. SAS, 38050 Grenoble Cedex 09 (FR)
(74) Mandataire: Tripodi, Paul

(56) Documents cités:
- EP-A- 0 109 881
- EP-A- 0 161 984
- FR-A- 2 776 840
- US-A1- 2004 257 731

## Description

### DOMAINE TECHNIQUE DE L'INVENTION

L'invention est relative à un bus de communication ayant au moins une paire de lignes de communication destinée à être branchée en série respectivement à des conducteurs d'un bus principal de communication destiné à être relié à des dispositifs communicants d'au moins un tableau électrique. Ledit bus de communication comporte au moins deux sorties de dérivation ayant chacune au moins deux lignes de dérivation. Lesdites lignes de dérivation ont respectivement une première extrémité reliée à une ligne de communication et ont une seconde extrémité destinée au branchement des dispositifs communicants.

### ETAT DE LA TECHNIQUE

L'utilisation de dispositifs communicants 1 dans les tableaux électriques 4 est de plus en plus courante. Lorsque ces dispositifs communicants 1 sont associés à d'autres appareillages installés dans un tableau électrique 4, notamment des dispositifs de coupure, ces dispositifs communicants fournissent par exemple des informations relatives aux états de fonctionnement desdits appareillages.

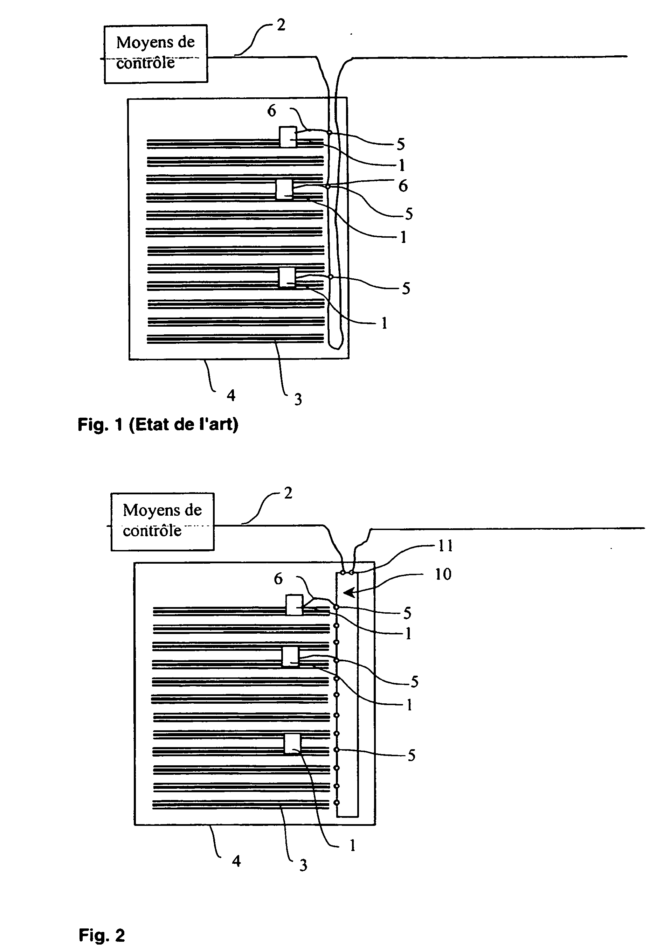

Comme représenté sur la figure 1, les dispositifs communicants 1 sont reliés par dérivation à un bus principal de communication 2 lui-même branché à des moyens de traitement de données 7. Le bus principal de communication 2 se présente généralement sous la forme d'un câble blindé ayant au moins une paire torsadée de conducteurs.

Il existe plusieurs familles de tableaux électriques comportant chacune des moyens de fixation des appareils électriques.

Dans certains tableaux visés, les appareillages et les dispositifs communicants sont disposés sur des platines de fixation ou dans des tiroirs, lesquels sont fixés sur les montants verticaux des tableaux par des moyens de fixation répartis uniformément sur toute la hauteur des tableaux. Les moyens de fixation sont disposés régulièrement à un pas régulier formant le pas élémentaire du tableau. Les appareillages et dispositifs communicants d'une unité fonctionnelle sont pré-installés sur une platine ou un tiroir. Cette pré-installation est réalisée à l'extérieur du tableau. Les platines de fixation ou tiroirs sont ensuite montés dans le tableau via les moyens de fixation. Le ou les dispositifs communicants sont ensuite raccordés par dérivation au bus principal de dérivation via une ligne dérivation.

Dans certains tableaux plus petits tels que des coffrets, les dispositifs communicants 1 sont disposés sur des rails de fixation 3 horizontaux fixés sur les montants verticaux. Des moyens de fixation répartis uniformément sur toute la hauteur des parois latérales des tableaux électriques 4, permettent de fixer les rails de fixation 3 de façon parallèle. Les moyens de fixation sont disposés régulièrement à un pas régulier formant le pas élémentaire du tableau. Les distances séparant les rails de fixation sont égales soit à celle d'un pas élémentaire du tableau soit à un multiple dudit pas élémentaire.

Dans d'autres types de tableaux d'automatismes, les appareillages électriques et dispositifs communicants de toutes les unités fonctionnelles sont placés sur une platine unique préalablement implantée dans le tableau électrique.

De manière générale, l'installation terminée, les dispositifs communicants 1 se trouvent répartis sur toute la hauteur du tableau électrique 4 et doivent être reliés au bus principal de communication 2 (voir EP 0 161 984).

L'installateur électricien doit brancher par dérivation tous les dispositifs communicants 1 sur des sorties de dérivation 5 du bus principal de communication 2. Chaque dispositif communicant 1 est relié aux sorties de dérivation 5 via une ligne de dérivation 6. La ligne de dérivation 6 est connectée au câble blindé à paire(s) torsadée(s) du bus principal de communication 2 par un connecteur de dérivation. Le câble blindé à paire(s) torsadée(s) du bus principal de communication 2 effectue de préférence un aller retour sur toute la hauteur du tableau électrique.

En pratique, l'installateur devra placer sur le câble blindé à paire(s) torsadée(s), à chaque sortie de dérivation 5, un connecteur de dérivation. Cette opération est relativement longue et fastidieuse.

En outre, le fait d'insérer des connecteurs de dérivation le long du câble risque de modifier l'impédance caractéristique Z0 de ce dernier. Ces modifications d'impédance caractéristique Z0 peuvent être responsables de pertes d'information parmi les informations transmises ou reçues. On peut aussi observer un ralentissement du débit de transmission desdites informations.

Par ailleurs, lorsque le nombre de lignes de dérivation 6 branchées sur les sorties de dérivation 5 est trop important par rapport à la longueur du bus principal de communication 2, il peut aussi être observé une variation néfaste de l'impédance caractéristique du bus de communication. La somme des longueurs de lignes de dérivation acceptable est proportionnelle à la longueur totale de bus de communication. En pratique, lorsque l'on souhaite utiliser un grand nombre de lignes de dérivation, il faut allonger le bus principal de communication en conséquence.

Afin de minimiser ces défauts de désadaptation du bus principal de communication, l'installateur peut être amené à limiter le nombre de sorties de dérivation 5 dans un tableau 4. En pratique, le pas de dérivation p observé généralement dans des installations électriques est supérieur à 12cm. Ce pas de dérivation p est généralement supérieur au pas élémentaire séparant des moyens de fixation des rails, des platines de fixation ou des tiroirs. Ainsi, chaque sortie de dérivation 5 n'est pas obligatoirement en face d'un dispositif de communicant 1. Le positionnement d'une ligne de dérivation 6 reliant un dispositif communicant 1 à une sortie de dérivation 5 devient plus complexe à réaliser.

Le bus principal de communication 2 comporte aussi généralement deux conducteurs destinés à l'alimentation électrique des dispositifs communicants. Ces conducteurs d'alimentation sont intégrés dans le câble blindé à paire(s) torsadée(s). Compte tenu de la longueur du bus principal de communication 2, il peut être observé une chute de tension significative en bout de bus.

Au moment de la conception d'une installation, l'installateur électricien peut être amené à faire un compromis entre la longueur totale des lignes de dérivation 6 et la chute de tension acceptable sur la longueur dudit bus.

Soit l'installateur privilégie le nombre de sorties de dérivation 5 au détriment du maintien de la tension le long du bus de communication 10. En effet, plus la longueur totale de lignes de dérivation 6 est importante, plus le bus de communication est long et plus la chute de tension observée en bout de bus principal de communication est significative.

Soit, l'installateur minimise la chute tension le long du bus de communication et limite le nombre de lignes de dérivation 6 à installer.

### EXPOSE DE L'INVENTION

L'invention vise donc à remédier aux inconvénients de l'état de la technique, de manière à proposer un bus de communication comportant un grand nombre de sorties de dérivation tout en limitant la chute de tension observée en bout de bus de communication.

Les lignes de communication selon un mode de réalisation de l'invention sont gravées sur une première couche conductrice d'un circuit imprimé, et les lignes de dérivation sont gravées sur une seconde couche conductrice dudit circuit imprimé. Les lignes de communication sont séparées l'une de l'autre par une distance comprise entre 1 mm et 15 mm, la section de chaque ligne de communication étant supérieure à 0.1 mm², la section de chaque ligne de dérivation étant supérieure à 0.01 mm². La première et seconde couches conductrices sont séparées par une distance supérieure à 1,4 mm

Avantageusement les lignes de communication ont une largeur comprise entre 1 mm et 6 mm et une épaisseur comprise entre 30 µm et 110 µm.
Les lignes de dérivation ont une largeur comprise entre 0,2 mm et 3 mm, une épaisseur comprise entre 30 µm et 110 µm, les lignes de dérivation étant séparées l'une de l'autre pas une distance comprise entre 1 mm et 15 mm.

Selon un mode de développement de l'invention, au moins un conducteur de masse est relié à chaque sortie de dérivation respectivement par une ligne de masse.

Selon un mode de développement de l'invention, le bus de communication comprend deux conducteurs d'alimentation en tension électrique destinés à l'alimentation des dispositifs communicants.

De préférence, les deux conducteurs d'alimentation en tension électrique sont destinés à être branchés par dérivation à une ligne principale d'alimentation reliant un ou plusieurs tableaux électriques à une source principale de tension.

Dans un mode de réalisation de l'invention, les lignes de communications comportent un premier tronçon aller et un second tronçon retour, les premiers et seconds tronçons s'étendant parallèlement sur la longueur du bus et étant reliés en série par une de leur extrémité.

Avantageusement, les lignes de dérivation sont reliées alternativement aux tronçons aller et aux tronçons retour.

Avantageusement, les lignes de dérivation sont perpendiculaires aux lignes de communication.

Dans un mode de réalisation particulier, le circuit imprimé comporte à une extrémité, des moyens de connexion destinés à abouter ledit bus à un second bus de communication.

Avantageusement, les moyens de connexion sont aptes à connecter les lignes de communication d'un premier bus et d'un second bus de manière à former un enroulement desdites lignes, le pas d'enroulement des lignes de communication correspondant sensiblement à la longueur du circuit imprimé d'un bus de communication.

Dans un mode de réalisation particulier, le circuit imprimé est entouré par un blindage métallique sur toute la longueur du bus de communication ou des bus de communication aboutés.

Avantageusement, le blindage métallique est relié électriquement au conducteur de masse du circuit imprimé et comporte des moyens de fixation destinés à fixer sa structure mécanique à un tableau électrique et à raccorder électriquement le blindage à la masse du tableau électrique.

De préférence, l'impédance caractéristique du bus de communication est comprise entre 100 et 150Ω.

De préférence, le pas de dérivation entre deux sorties de dérivation est inférieur ou égal à 50 millimètres.

Avantageusement, les secondes extrémités des lignes de dérivation forment avec le bord du circuit imprimé les empreintes destinées à recevoir des connecteurs électriques de dispositifs communicants.

Avantageusement, les lignes de communications ne sont pas rectilignes et comportent respectivement des déformations locales réparties le long desdites lignes.

Avantageusement, les déformations locales sont constituées de chicanes comportant au moins deux tronçons linéaires conducteur.

Avantageusement, les lignes de communications comportent respectivement au moins une prise de liaison destinée à connecter en série un tronçon de câble blindé à paire(s) torsadée(s).

Un tableau électrique comprend des moyens de fixation destinés au maintien de rails de fixation ou de platines de fixation pour des dispositifs communicants, les moyens de fixation étant répartis uniformément selon un pas élémentaire sur la hauteur dudit tableau. Le tableau électrique comprend au moins un bus de communication tel que défini ci-dessus, les sorties de dérivation du bus de communication étant réparties uniformément selon un pas égal à un multiple du pas élémentaire du tableau.

Avantageusement, les sorties de dérivation du bus de communication étant réparties uniformément selon un pas régulier sensiblement égal au pas élémentaire du tableau

De préférence, le bus de communication est positionné de manière à ce que chaque rail ou platine de fixation soit en vis à vis avec une sortie de dérivation.

### BREVE DESCRIPTION DES FIGURES

D'autres avantages et caractéristiques ressortiront plus clairement de la description qui va suivre d'un mode particulier de réalisation de l'invention, donné à titre d'exemple non limitatif, et représenté aux dessins annexés sur lesquels :
- la figure 1 représente une vue schématique d'une installation de type connu comprenant au moins un tableau électrique ayant des dispositifs communicants reliés à un bus de communication ;
- la figure 2 représente une vue schématique d'une installation comprenant au moins un tableau électrique comportant un bus de communication selon les différents modes de réalisation de l'invention ;
- la figure 3 représente une vue schématique en coupe d'un bus de communication selon un premier mode de réalisation de l'invention ;
- la figure 4 représente une vue de dessus d'un bus de communication selon la figure 3 ;
- la figure 5 représente une vue schématique en coupe d'un bus de communication selon un second mode de réalisation de l'invention;
- la figure 6 représente une vue de dessus d'un bus de communication selon la figure 5 ;
- la figure 7 représente une vue schématique en coupe d'un bus de communication selon un troisième mode de réalisation de l'invention ;
- la figure 8 représente une vue de dessus d'un bus de communication selon la figure 7 ;

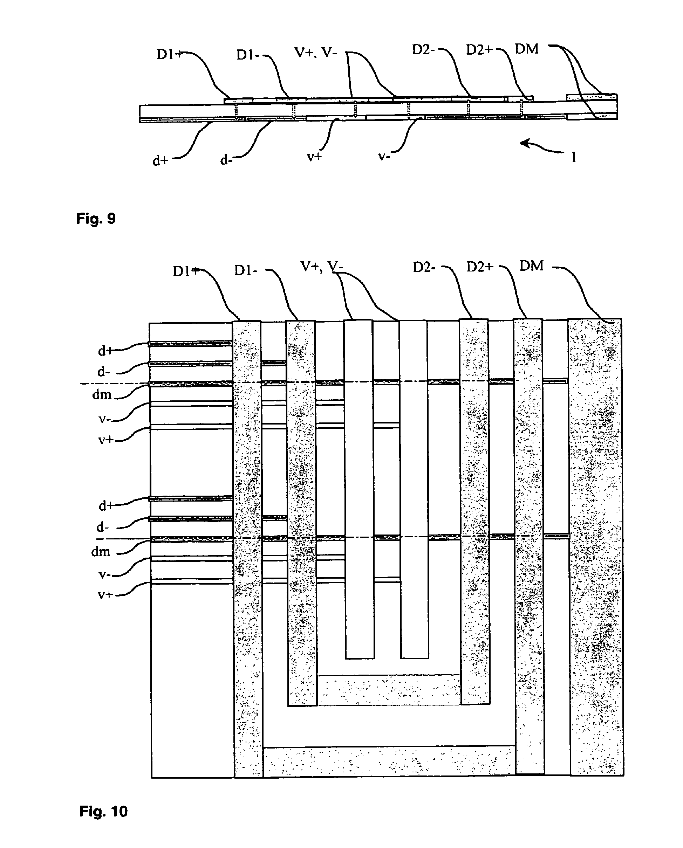

- la figure 9 représente une vue schématique en coupe d'un bus de communication selon une variante de réalisation des différents modes de réalisation de l'invention;
- la figure 10 représente une vue de dessus d'un bus de communication selon la figure 9 ;
- la figure 11 représente une vue schématique d'un bus de communication selon un quatrième mode de réalisation de l'invention;
- la figure 12 représente une vue schématique de l'assemblage de trois bus de communication selon les modes de réalisation de l'invention ;
- les figures 13 et 14 représentent des vues schématiques de variantes de réalisation des différents modes de réalisation de l'invention.

### DESCRIPTION DETAILLEE D'UN MODE DE REALISATION

Le bus de communication 10 selon des modes de réalisation de l'invention, est destiné de préférence à être installé à demeure et de manière indépendante dans un tableau électrique 4. Le bus de communication 10 comporte alors des moyens de branchement 11 en série d'une paire de lignes de communication D+, D- à celles d'un bus principal de communication 2. Ils ont de préférence une même impédance caractéristique. Le bus principal de communication 2 relie un ou plusieurs tableaux électriques 4 à des moyens de traitement de données. Généralement, le bus principal de communication 2 se présente sous la forme d'un câble blindé à paire(s) torsadée(s).

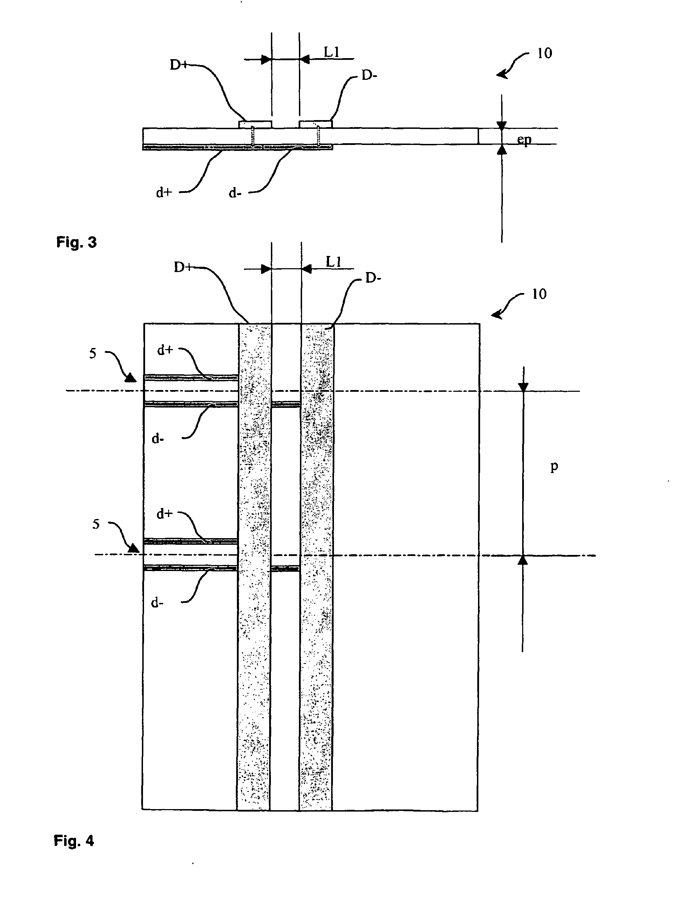

Selon un premier mode de réalisation préférentiel de l'invention, représenté sur les figures 3 et 4, le bus de communication 10 comporte un support allongé composé d'un circuit imprimé ayant au moins deux couches conductrices.

Une paire de lignes de communication D+, D- est réalisée par gravure sur une première couche. Comme représenté sur la figure 4, le bus de communication 10 comporte au moins deux sorties de dérivation 5 ayant chacune au moins deux lignes de dérivation d+, d-. Les lignes de dérivation d+, d- ont deux extrémités. Une première extrémité est reliée aux lignes de communication d+, d-.
Une seconde extrémité est destinée au branchement des dispositifs communicants. Les lignes de dérivation d+, d- sont gravées sur une seconde couche conductrice dudit circuit imprimé.

Les lignes de communication D+, D- sont destinées à être branchées en série respectivement à des conducteurs d'une paire torsadée d'un câble blindé d'un bus principal de communication, avantageusement de même impédance caractéristique Z0. Des moyens de branchement 11 permettent de faire la liaison électrique entre le bus de communication 10 et le bus principal de communication 2.

Dans l'exemple de réalisation décrit, l'épaisseur de chaque couche conductrice du circuit imprimé est comprise entre 30 et 110 µm, de préférence entre 35 et 105 µm. La première et la seconde couches conductrices sont séparées par une distance ep supérieure à 1,4 mm. A titre d'exemple, la distance ep est égale à 1,6 mm. Cette cote correspond à l'épaisseur d'un circuit imprimé standard.

Afin que le bus de communication comporte une impédance caractéristique comprise entre 100 et 150 Ohms sur toute la longueur du circuit imprimé, les lignes de communication D+, D- sont séparées l'une de l'autre par une distance L1 comprise entre 1 mm et 15 mm. En outre, la section de chaque ligne de communication D+, D- est supérieure à 0.1 mm². Enfin, la section de chaque ligne de dérivation d+, d- est supérieure à 0.01 mm².

Dans l'exemple de réalisation, les lignes de dérivation d+, d- sont perpendiculaires aux lignes de communication D+, D-. Le pas de dérivation p entre deux sorties de dérivation 5 est inférieur ou égal à 50 millimètres. Les lignes de communication D+, D- ont une largeur L comprise entre 1 mm et 6 mm. Par ailleurs, les lignes de dérivation d+, d- ont une largeur comprise entre 0,2 mm et 3 mm. Les lignes de dérivation d+, d- sont séparées l'une de l'autre pas une distance comprise entre 1 mm et 15 mm. L'impédance caractéristique Z0 du bus de communication est alors comprise entre 100 et 150Ω.

Compte tenu du positionnement des lignes de dérivation d+, d- sur le circuit imprimé, les secondes extrémités desdites lignes forment avec le bord du circuit imprimé les empreintes destinées à recevoir des connecteurs électriques de dérivation. Lesdits connecteurs électriques 30 encartables permettent de connecter les lignes de dérivation 6 des dispositifs communicants 1 au bus de communication 10.

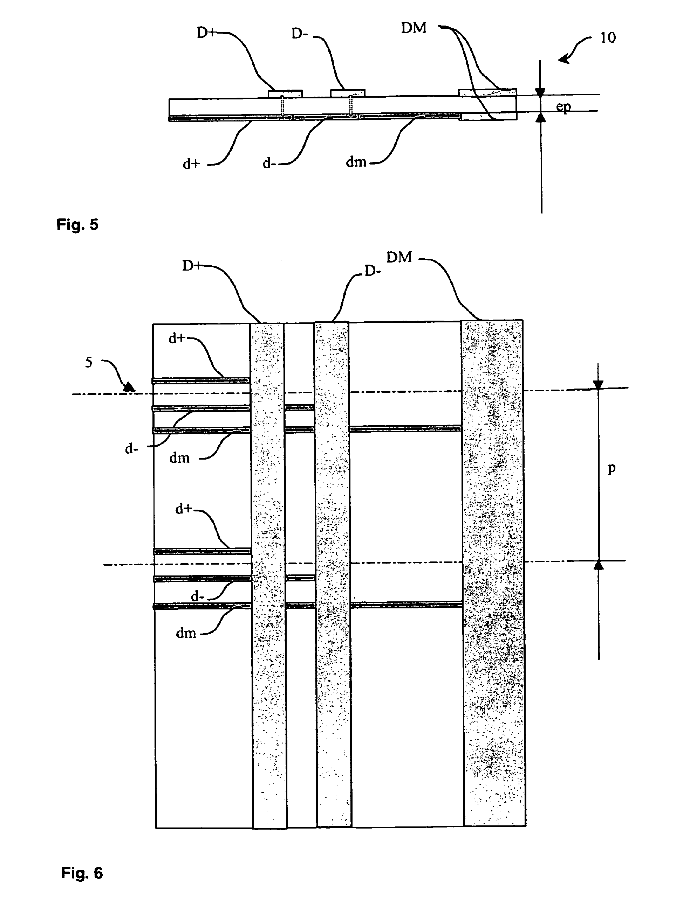

Comme représenté sur les figures 5 et 6, le bus de communication 10 selon un second mode de réalisation préférentiel de l'invention comprend au moins un conducteur de masse DM. Ledit conducteur est disposé parallèlement aux deux autres lignes de communication d+, d-. Le conducteur de masse DM est relié à chaque sortie de dérivation 5 respectivement par une ligne de masse dm. La ligne de masse dm est de préférence placée perpendiculairement au conducteur de masse DM. La ligne de masse dm est gravée sur la seconde couche conductrice du circuit imprimé, parallèlement aux lignes de dérivation d+, d-.

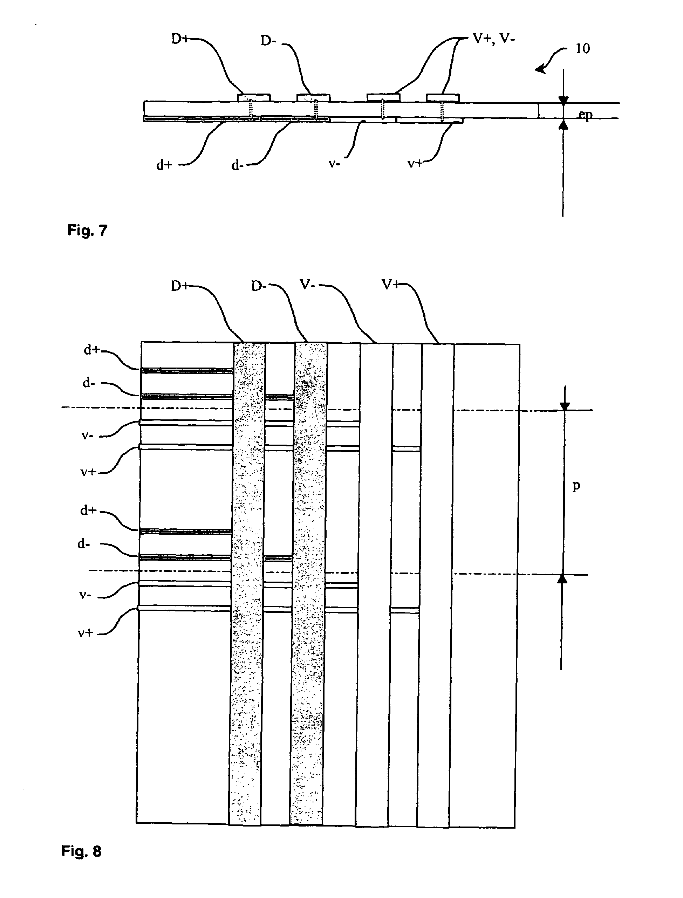

Comme représenté sur les figures 7 et 8, le bus de communication selon un troisième mode de réalisation préférentiel de l'invention comprend deux conducteurs d'alimentation en tension électrique V+, V- destinés à l'alimentation des dispositifs communicants 1. Lesdits conducteurs sont disposés parallèlement aux deux lignes de communication d+, d-. Les conducteurs d'alimentation V+, V-sont reliés à chaque sortie de dérivation 5 respectivement par des lignes d'alimentation v+, v-. En outre, les deux conducteurs d'alimentation V+, V- ont une de leur extrémité destinée à être branchées par dérivation à une ligne principale d'alimentation reliant un ou plusieurs tableaux électriques à une source principale de tension. La ligne principale d'alimentation est généralement intégrée dans le câble blindé à paire(s) torsadée(s) du bus principal de communication 2.

De manière générale, les lignes de communication D+, D- selon les différents modes de réalisation de l'invention sont reliées en série avec les conducteurs du bus principal de communication 2. Chaque ligne de communication D+, D- comporte une première extrémité destinée à être branchée au bus principal de communication.

Selon une première variante de réalisation, chaque ligne de communication D+, D- comporte une seconde extrémité destinée à être branchée en série au bus principal de communication 2 via un câble blindé à paire(s) torsadée(s) d'une longueur sensiblement égale à celle du bus de communication 10.

Selon une seconde variante de réalisation, les lignes de communications D+, D- du bus de communication sont composées chacune de deux tronçons ; un premier tronçon aller D1+, D1- et un second tronçon retour D2+, D2-. Les tronçons aller et les tronçons retour reliés en série par une de leur extrémité s'étendent parallèlement sur la longueur du circuit imprimé. Les extrémités libres du tronçon aller et du tronçon retour d'un même ligne de communication sont reliées en série via des moyens de connexion à des conducteurs d'un bus principal de communication 2.

Selon une autre variante de réalisation, les lignes de dérivation d+, d- sont reliées alternativement aux tronçons aller D1+, D1- et aux tronçons retour D2+, D2-. Cette répartition géographique des connexions permet une meilleure répartition de capacités ramenées par les lignes de dérivation sur les tronçons aller ou retour. Cette configuration tend à limiter les désadaptations d'impédance et les dispersions entre le tronçon aller et le tronçon retour.

Les capacités de couplage entre les lignes de communication et les lignes de dérivation influent sur l'obtention de l'impédance caractéristique Z0 du bus de communication. Afin que les capacités de couplage soient équivalentes entre d'une part les lignes de dérivation et les tronçons aller et d'autre part entre les lignes de dérivation et le tronçon retour, il peut être envisagé d'utiliser une longueur de piste identique pour toutes les lignes de masse dm, les lignes d'alimentation V+, V- ainsi que les lignes de dérivation d+, d-. Cette longueur universelle de piste de circuit imprimé correspond sensiblement à la largeur du circuit imprimé.

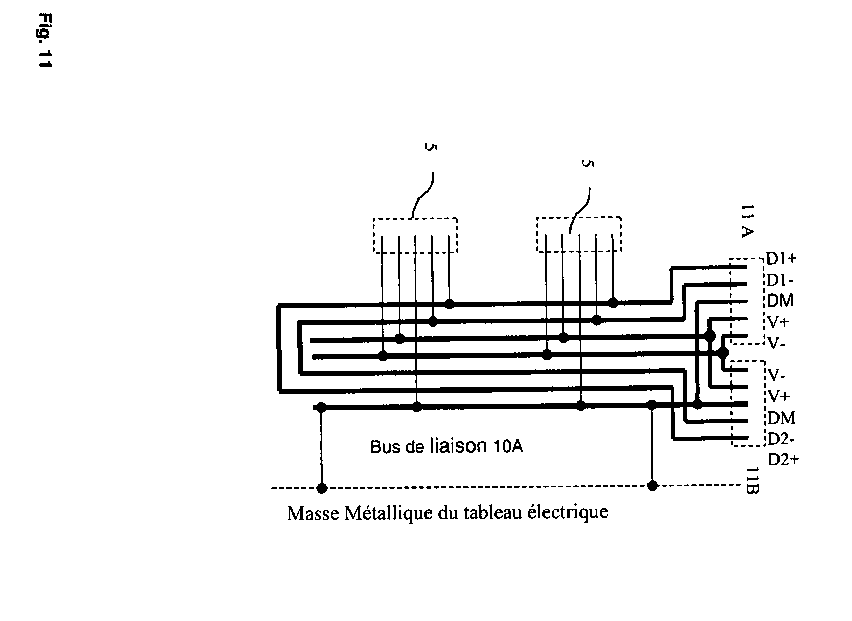

Selon un quatrième mode de réalisation préférentiel de l'invention, le bus de communication 10 comporte des lignes de communication D+, D-, des lignes de masse et des conducteurs d'alimentation connus dans les trois modes de réalisation préférentiels de l'invention. Comme représenté sur la figure 11, l'extrémité du circuit imprimé qui est destinée à être reliée au bus principal de communication 2 permet d'une part de relier en série chacune des deux lignes de communication D+, D- en série à des conducteurs de communication du bus principal 2. D'autre part, l'extrémité du circuit imprimé permet de relier en dérivation les deux conducteurs d'alimentation V+, V- à une ligne principale d'alimentation.

En fonction du type d'installation et de la taille des tableaux électriques 4, il peut s'avérer que le bus de communication 10 selon l'un quelconque des modes de réalisation de l'invention ne soit pas assez long par rapport à la hauteur du tableau. La longueur du bus de communication proportionnelle à celle du circuit imprimé, est directement dépendante des moyens ou des techniques de fabrication standardisées de circuits imprimés. Suivant les modes de réalisation décrits, les circuits imprimés ont une longueur maximale de l'ordre de soixante centimètres. Ainsi, les bus de communication 10 ont une longueur sensiblement égale à 0,6 mètres. Lorsque les tableaux électriques utilisés ont une hauteur standardisée de l'ordre de 1.50 à 1,80 mètres, il est alors nécessaire d'utiliser plusieurs bus de communication 10. Lesdits bus comportent alors, à une extrémité du circuit imprimé, des moyens de connexion destinés à abouter un premier bus 10 à au moins un second bus de communication 10.

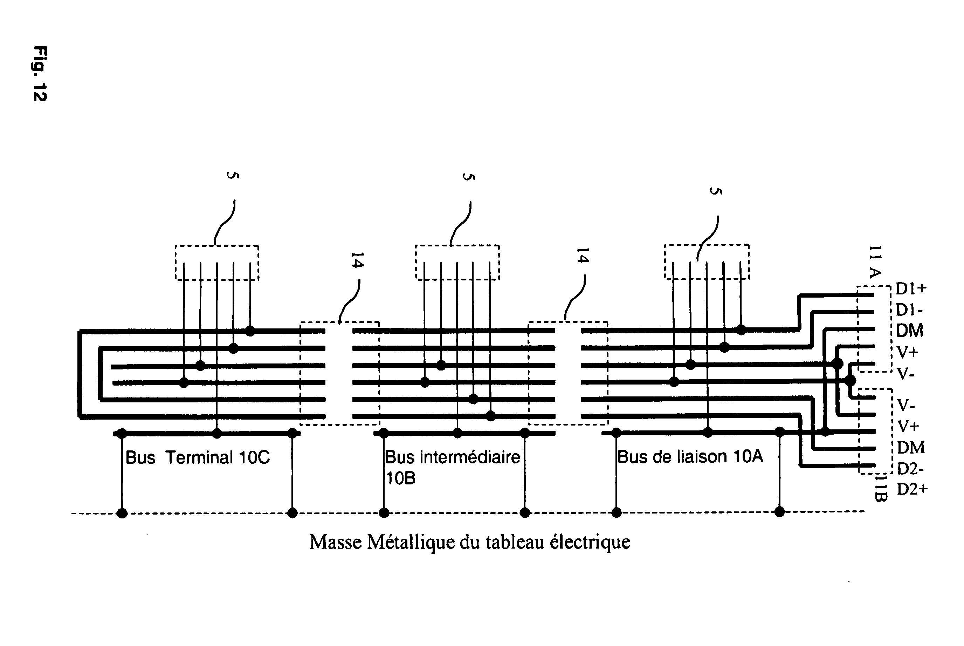

Comme représenté sur la figure 12, trois bus de communication selon l'invention sont aboutés en série. De préférence, les circuits imprimés des trois bus de communication sont sensiblement de même longueur. Par la suite, les trois bus sont appelés respectivement bus de liaison 10A, bus intermédiaire 10B et bus terminal 10C. Des moyens de connexion 14 permettent de relier les bus de communication 10 entre eux. Le bus de liaison 10A est destiné à être connecté aux conducteurs du bus principal de communication 2 via des moyens de branchement d'entrée et de sortie 11 A, 11 B. Ces trois bus de communication 10 comportent respectivement deux lignes de communication composées chacune d'un premier tronçon aller D1+, D1- et d'un second tronçon retour D2+, D2-. En outre, chacun des bus de communication 10 comporte au moins un conducteur de masse DM relié à chaque sortie de dérivation 5 respectivement par une ligne de masse dm. Enfin, les bus de communication comprennent deux conducteurs d'alimentation en tension électrique V+, V- disposés parallèlement aux tronçons aller et retour des lignes de communication. Les conducteurs d'alimentation V+, V-sont reliés à chaque sortie de dérivation 5 respectivement par des lignes d'alimentation v+, v-.

Il peut être envisager que les moyens de connexion 14 entre le bus de liaison 10A, le bus intermédiaire 10B et le bus terminal 10C soient aptes à connecter les lignes de communication D+, D- de deux bus adjacents de manière à former un enroulement desdites lignes. Le pas d'enroulement des lignes de communication D+, D- correspond sensiblement à la longueur d'un circuit imprimé d'un bus de communication 10A, 10B, 10C. Cet enroulement permet de reconstituer une torsade équivalente à celle présente dans un câble blindé à paire torsadée. Le rôle de la torsade est de minimiser les tensions induites par des champs électromagnétiques perturbateurs. En effet, la tension induite dans une boucle étant annulée par la tension inverse induite dans la boucle suivante.

Selon une autre variante de réalisation de l'invention, le circuit imprimé du bus de communication 10 est entouré par un blindage métallique sur toute la longueur du bus de communication ou des bus de communication aboutés. Le blindage métallique est relié électriquement en différents points au conducteur de masse DM, du circuit imprimé. Par ailleurs, le blindage comporte des moyens de fixation destinés à fixer sa structure mécanique à un tableau électrique 4 et à raccorder électriquement le blindage à la masse du tableau électrique.

Afin d'augmenter la longueur maximale de lignes de dérivation utilisable sur un bus de communication selon les différents modes de réalisation de l'invention, une variante de réalisation consiste à augmenter la longueur des lignes de communication D+, D- sans changer la longueur apparente du bus de communication 10. Deux solutions décrites ci-dessous peuvent être mises en oeuvre de manière indépendante ou en combinaison.

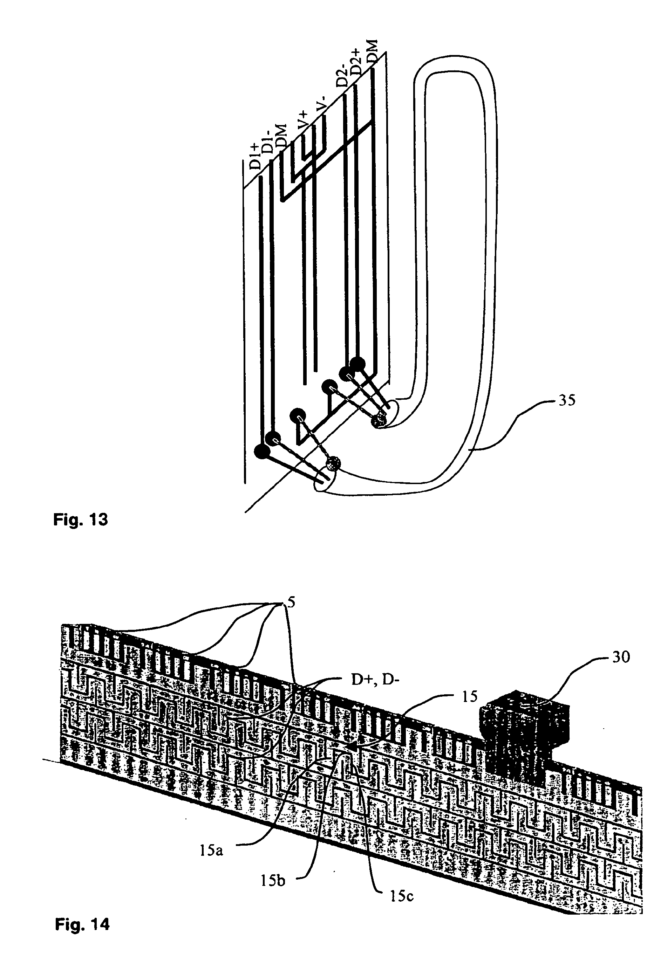

Une première solution consiste à réaliser des lignes de communication D+; D- non rectilignes. Chaque ligne de communication s'étendant sur toute la longueur du circuit imprimé comporte un certain nombre de déformations locales. Comme représenté sur la figure 14, à titre d'exemple, les déformations locales peuvent prendre la forme de chicanes 15 composées de trois tronçons conducteurs 15a, 15b, 15c linéaires. De préférence, les tronçons 15a, 15b, 15c sont reliés entre eux de manière perpendiculaire. Les chicanes sont réparties linéairement et uniformément sur toute la longueur des lignes de communication D+, D-. Pour une longueur donnée de circuit imprimé, ces chicanes permettent approximativement de doubler la longueur de chaque ligne de communication. La forme de chaque déformation locale n'est pas limitée à celle d'une chicane à trois cotés. On peut envisager des déformations locales ayant des formes de spirale ou des formes circulaires.

Une seconde solution consiste à placer sur les lignes de communication D+, D- au moins une prise de liaison destinée à connecter en série un tronçon 35 de câble blindé à paire(s) torsadée(s). Comme représenté sur la figure 13, les lignes de communication se composent alors d'au moins deux parties. Au moins une première partie conductrice est gravée sur le circuit imprimé et fait partie intégrante dudit circuit. Au moins une seconde partie est constituée d'un tronçon 35 souple de câble blindé à paire(s) torsadée(s). La longueur totale des lignes de communication peut être ainsi allongée sans changer la longueur du circuit imprimé du bus de communication 10. Cette seconde solution peut comporter plusieurs prises de liaison pouvant être utilisées pour connecter en série plusieurs tronçons 35 de câble blindé à paire(s) torsadée(s).

On peut bien évidemment utiliser les deux solutions en combinaison pour bénéficier des avantages de chacune.

Par ailleurs, le bus de communication 10 selon les différents modes de réalisation l'invention peut être intégré dans un tableau électrique 4. Ledit tableau électrique comprend des moyens de fixation destinés au maintien de rails de fixation 3 ou de platines de fixation. Lesdits rails ou lesdites platines sont destinées à recevoir notamment des dispositifs communicants. Les moyens de fixation sont répartis uniformément selon un pas élémentaire sur la hauteur dudit tableau. Le tableau comporte au moins un bus de communication 10 ayant des sorties de dérivation 5. Lesdites sorties sont réparties uniformément selon un pas égal à un multiple du pas élémentaire du tableau. Dans le mode de réalisation décrit, les sorties de dérivation 5 du bus de communication 10 sont réparties uniformément, de préférence, selon un pas régulier sensiblement égal au pas élémentaire du tableau. Avantageusement, le bus de communication 10 est positionné de manière à ce que chaque rail ou platine fixation 3 ou soit en vis à vis avec une sortie de dérivation 5.

## Revendications

1. Bus de communication (10) ayant au moins une paire de lignes de communication (D+, D-) destinée à être branchée en série respectivement à des conducteurs d'un bus principal de communication (2) destiné à être relié à des dispositifs communicants (1) d'au moins un tableau électrique (4), ledit bus de communication comportant au moins deux sorties de dérivation (5) ayant chacune au moins deux lignes de dérivation (d+, d-), lesdites lignes de dérivation (d+, d-) ayant respectivement une première extrémité reliée à une ligne de communication (D+, D-) et ayant une seconde extrémité destinée au branchement des dispositifs communicants (1),
**caractérisé en ce que :**
• les lignes de communication (D+, D-) sont gravées sur une première couche conductrice d'un circuit imprimé, et les lignes de dérivation (d+, d-) sont gravées sur une seconde couche conductrice dudit circuit imprimé,
• les lignes de communication (D+, D-) sont séparées l'une de l'autre par une distance (L1) comprise entre 1 mm et 15 mm, la section de chaque ligne de communication (D+, D-) étant supérieure à 0.1 mm²,
• la section de chaque ligne de dérivation (d+, d-) étant supérieure à 0.01 mm²,
• la première et seconde couches conductrices sont séparées par une distance (ep) supérieure à 1,4 mm.

2. Bus de communication selon la revendication 1 ou 2 **caractérisé en ce que**
• les lignes de communication (D+, D-) ont une largeur (L) comprise entre 1 mm et 6 mm et une épaisseur comprise entre 30 µm et 110 µm,
• les lignes de dérivation (d+, d-) ont une largeur comprise entre 0,2 mm et 3 mm, une épaisseur comprise entre 30 µm et 110 µm, les lignes de dérivation (d+, d-) étant séparées l'une de l'autre par une distance comprise entre 1 mm et 15 mm.

3. Bus de communication selon l'une quelconque des revendications précédentes **caractérisé en ce qu'**il comprend au moins un conducteur de masse (DM), relié à chaque sortie de dérivation (5) respectivement par une ligne de masse (dm).

4. Bus de communication selon l'une quelconque des revendications précédentes **caractérisé en ce qu'**il comprend deux conducteurs d'alimentation en tension électrique (V+, V-) destinés à l'alimentation des dispositifs communicants (2).

5. Bus de communication selon la revendication 4 **caractérisé en ce que** les deux conducteurs d'alimentation en tension électrique (V+, V-) sont destinés à être branchés par dérivation à une ligne principale d'alimentation reliant un ou plusieurs tableaux électriques à une source principale de tension.

6. Bus de communication selon l'une quelconque des revendications précédentes **caractérisé en ce que** les lignes de communications (D+, D-) comportent un premier tronçon aller (D1+, D1-) et un second tronçon retour (D2+, D2-), les premiers et seconds tronçons s'étendant parallèlement sur la longueur du bus et étant reliés en série par une de leur extrémité.

7. Bus de communication selon la revendication 6 **caractérisé en ce que** les lignes de dérivation (d+, d-) sont reliées alternativement aux tronçons aller (D1+, D1-) et aux tronçons retour (D2+, D2-).

8. Bus de communication selon l'une quelconque des revendications précédentes **caractérisé en ce que** les lignes de dérivation (d+, d-) sont perpendiculaires aux lignes de communication (D+, D-).

9. Bus de communication selon la revendication 8 **caractérisé en ce qu'**il comporte, à une extrémité du circuit imprimé, des moyens de connexion (14) destinés à abouter ledit bus à un second bus de communication.

10. Bus de communication selon la revendication 9 **caractérisé en ce que** les moyens de connexion (14) sont aptes à connecter les lignes de communication (D+, D-) d'un premier bus et d'un second bus de manière à former un enroulement desdites lignes, le pas d'enroulement des lignes de communication (D+, D-) correspondant sensiblement à la longueur du circuit imprimé d'un bus de communication.

11. Bus de communication selon l'une quelconque des revendications précédentes **caractérisé en ce que** le circuit imprimé est entouré par un blindage métallique sur toute la longueur du bus de communication ou des bus de communication aboutés.

12. Bus de communication selon la revendication 11 **caractérisé en ce que** le blindage métallique est relié électriquement au conducteur de masse (DM) du circuit imprimé et comporte des moyens de fixation destinés à fixer sa structure mécanique à un tableau électrique et à raccorder électriquement le blindage à la masse du tableau électrique.

13. Bus de communication selon l'une quelconque des revendications précédentes **caractérisé en ce que** son impédance caractéristique (Z0) est comprise entre 100 et 150 Q.

14. Bus de communication selon l'une quelconque des revendications précédentes **caractérisé en ce que** le pas de dérivation (p) entre deux sorties de dérivation (5) est inférieur ou égal à 50 millimètres.

15. Bus de communication selon l'une quelconque des revendications précédentes **caractérisé en ce que** les secondes extrémités des lignes de dérivation (d+, d-) forment avec le bord du circuit imprimé les empreintes destinées à recevoir des connecteurs électriques de dispositifs communicants (1).

16. Bus de communication selon l'une quelconque des revendications précédentes **caractérisé en ce que** les lignes de communications (D+, D-) ne sont pas rectilignes et comportent respectivement des déformations locales réparties le long desdites lignes.

17. Bus de communication selon la revendication 16 **caractérisé en ce que** les déformations locales sont constituées de chicanes (15) comportant au moins deux tronçons linéaires conducteurs (15a, 15b, 15c).

18. Bus de communication selon l'une quelconque des revendications précédentes **caractérisé en ce que** les lignes de communications (D+, D-) comportent respectivement au moins une prise de liaison destinée à connecter en série un tronçon de câble blindé à paire(s) torsadée(s).

19. Tableau électrique comprenant des moyens de fixation destinés au maintien de rails de fixation (3) ou platines de fixation pour des dispositifs communicants 1, les moyens de fixation étant répartis uniformément selon un pas élémentaire sur la hauteur dudit tableau **caractérisé en ce qu'**il comporte au moins un bus de communication (10) selon les revendications précédentes, les sorties de dérivation (5) du bus de communication (10) étant réparties uniformément selon un pas égal à un multiple du pas élémentaire du tableau.

20. Tableau électrique selon la revendication 19 **caractérisé en ce que** les sorties de dérivation (5) du bus de communication (10) sont réparties uniformément selon un pas régulier sensiblement égal au pas élémentaire du tableau

21. Tableau électrique selon la revendication 20 **caractérisé en ce que** le bus de communication (10) est positionné de manière à ce que chaque rail ou platine de fixation soit en vis à vis avec une sortie de dérivation (5)

## Claims

1. A communication bus (10) having at least one pair of communication lines (D+, D-) designed to be connected in series respectively to conductors of a main communication bus (2) designed to be connected to communicating devices (1) of at least one electric panel (4), said communication bus comprising at least two branched outputs (5) each having at least two branch lines (d+, d-), said branch lines (d+, d-) respectively having a first end connected to a communication line (D+, D-) and having a second end designed for connection of the communicating devices (1),
**characterized in that:**
• the communication lines (D+, D-) are etched on a first conducting layer of a printed circuit, and the branch lines (d+, d-) are etched on a second conducting layer of said printed circuit,
• the communication lines (D+, D-) are separated from one another by a distance (L1) comprised between 1 mm and 15 mm, the cross-section of each communication line (D+, D-) being greater than 0.1 mm²,
• the cross-section of each branch line (d+, d-) is greater than 0.01 mm²,
• the first and second conducting layers are separated by a distance (th) greater than 1.4 mm.

2. The communication bus according to claim 1 or 2 **characterized in that**
• the communication lines (D+, D-) have a width (L) comprised between 1 mm and 6 mm and a thickness comprised between 30 µm and 110 µm,
• the branch lines (d+, d-) have a width comprised between 0.2 mm and 3 mm, and a thickness comprised between 30 µm and 110 µm, the branch lines (d+, d-) being separated from one another by a distance comprised between 1 mm and 15 mm.

3. The communication bus according to either one of the foregoing claims **characterized in that** it comprises at least one ground conductor (DM) connected to each branched output (5) respectively by a ground line (dm).

4. The communication bus according to any one of the foregoing claims **characterized in that** it comprises two electric power supply conductors (V+, V-) designed for supply of the communicating devices (2).

5. The communication bus according to claim 4 **characterized in that** the two electric power supply conductors (V+, V-) are designed to be branch-connected to a main power supply line connecting one or more electric panels to a main power supply source.

6. The communication bus according to any one of the foregoing claims **characterized in that** the communication lines (D+, D-) comprise a first outgoing section (D1+, D1-) and a second incoming section (D2+, D2-), the first and second sections extending in parallel over the length of the bus and being connected in series via their ends.

7. The communication bus according to claim 6 **characterized in that** the branch lines (d+, d-) are connected alternately to the outgoing sections (D1+, D1-) and to the incoming sections (D2+, D2-).

8. The communication bus according to any one of the foregoing claims **characterized in that** the branch lines (d+, d-) are perpendicular to the communication lines (D+, D-).

9. The communication bus according to claim 8 **characterized in that** it comprises connection means (14), at one end of the printed circuit, designed to abut said bus to a second communication bus.

10. The communication bus according to claim 9 **characterized in that** the connection means (14) are able to connect the communication lines (D+, D-) of a first bus and of a second bus so as to form a winding of said lines, the winding pitch of the communication lines (D+, D-) corresponding substantially to the length of the printed circuit of a communication bus.

11. The communication bus according to any one of the foregoing claims **characterized in that** the printed circuit is surrounded by a metal shielding over the whole length of the communication bus or of the abutted communication busses.

12. The communication bus according to claim 11 **characterized in that** the metal shielding is electrically connected to the ground conductor (DM) of the printed circuit and comprises fixing means designed to fix its mechanical structure to an electric panel and to electrically connect the shielding to the ground of the electric panel.

13. The communication bus according to any one of the foregoing claims **characterized in that** its characteristic impedance (Z0) is comprised between 100 and 150 Ω.

14. The communication bus according to any one of the foregoing claims **characterized in that** the branching pitch (p) between two branched outputs (5) is smaller than or equal to 50 millimetres.

15. The communication bus according to any one of the foregoing claims **characterized in that** the second ends of the branch lines (d+, d-) form, with the edge of the printed circuit, the imprints designed to receive electric connectors of communicating devices (1).

16. Communication bus according to any one of the foregoing claims **characterized in that** the communication lines (D+, D-) are not straight and respectively comprise local deformations staggered along said lines.

17. Communication bus according to claim 16 **characterized in that** the local deformations are formed by chicanes (15) comprising at least two linear conducting sections (15a, 15b, 15c).

18. Communication bus according to any one of the foregoing claims **characterized in that** the communication lines (D+, D-) respectively comprise at least one joining connector designed to connect a section of twisted pair(s) shielded cable in series.

19. An electric panel comprising fixing means designed to secure fixing rails (3) or mounting plates for communicating devices (1), the fixing means being uniformly staggered with an elementary pitch over the height of said panel, **characterized in that** it comprises at least one communication bus (10) according to the foregoing claims, the branched outputs (5) of the communication bus (10) being uniformly staggered with a pitch equal to a multiple of the elementary pitch of the panel.

20. The electric panel according to claim 19 **characterized in that** the branched outputs (5) of the communication bus (10) are uniformly staggered with a regular pitch substantially equal to the elementary pitch of the panel.

21. The electric panel according to claim 20 **characterized in that** the communication bus (10) is positioned in such a way that each rail or mounting plate is facing a branched output (5).

## Patentansprüche

1. Kommunikationsbus (10) mit mindestens zwei Kommunikationsleitungen (D+, D-) zum seriellen Anschluss an zugeordnete Leiter eines Haupt-Kommunikationsbusses (2), der zum Anschluss an Kommunikationseinrichtungen (1) mindestens einer elektrischen Schaltanlage (4) dient, wobei der genannte Kommunikationsbus mindestens zwei Abzweige (5) mit jeweils mindestens zwei Abzweigleitungen (d+, d-) umfasst, welche Abzweigleitungen (d+, d-) jeweils ein mit einer Kommunikationsleitung (D+, D-) verbundenes erstes Ende sowie ein zum Anschluss von Kommunikationseinrichtungen (1) dienendes zweites Ende aufweisen,
**dadurch gekennzeichnet, dass**
• die Kommunikationsleitungen (D+, D-) auf einer ersten leitenden Schicht einer Leiterplatte aufgeätzt sind und die Abzweigleitungen (d+, d-) auf einer zweiten leitenden Schicht einer Leiterplatte aufgeätzt sind,
• zwischen den Kommunikationsleitungen (D+, D-) ein Abstand (L1) zwischen 1 und 15 mm ausgebildet und der Querschnitt jeder Kommunikationsleitung (D+, D-) größer als 0,1 mm² ist,
• der Querschnitt jeder Abzweigleitung (d+, d-) größer als 0,01 mm² ist und
• zwischen der ersten und der zweiten leitenden Schicht ein Abstand (ep) von mehr als 1,4 mm ausgebildet ist.

2. Kommunikationsbus nach Anspruch 1 oder 2, **dadurch gekennzeichnet, dass**
• die Kommunikationsleitungen (D+, D-) eine Breite (L) zwischen 1 und 6 mm und eine Dicke zwischen 30 und 110 µm aufweisen,
• die Abzweigleitungen (d+, d-) eine Breite zwischen 0,2 und 3 mm sowie eine Dicke zwischen 30 und 110 µm aufweisen und zwischen den einzelnen Abzweigleitungen (d+, d-) ein Abstand zwischen 1 und 15 mm ausgebildet ist.

3. Kommunikationsbus nach irgendeinem der vorhergehenden Ansprüche, **dadurch gekennzeichnet, dass** er mindestens einen Masseleiter (DM) umfasst, der über eine zugeordnete Masseleitung (dm) an jeden Abzweig (5) angeschlossen ist.

4. Kommunikationsbus nach irgendeinem der vorhergehenden Ansprüche, **dadurch gekennzeichnet, dass** er zwei Stromversorgungsleiter (V+, V-) umfasst, die zur Stromversorgung der Kommunikationseinrichtungen (2) dienen.

5. Kommunikationsbus nach Anspruch 4, **dadurch gekennzeichnet, dass** die beiden Stromversorgungsleiter (V+, V-) dazu dienen, als Abzweig an eine Hauptversorgungsleitung angeschlossen zu werden, die eine oder mehrere elektrische Schaltanlagen mit einer Hauptspannungsquelle verbindet.

6. Kommunikationsbus nach irgendeinem der vorhergehenden Ansprüche, **dadurch gekennzeichnet, dass** die Kommunikationsleitungen (D+, D-) einen ersten Hinleitungsabschnitt (D1+, D1-) sowie einen zweiten Rückleitungsabschnitt (D2+, D2-) umfassen, wobei die genannten Hinleitungsabschnitte und Rückleitungsabschnitte über die gesamte Länge der Busses parallel zueinander verlaufen und über eines ihrer Enden seriell miteinander verbunden sind.

7. Kommunikationsbus nach Anspruch 6, **dadurch gekennzeichnet, dass** die Abzweigleitungen (d+, d-) abwechselnd an die Hinleitungsabschnitte (D1+, D1-) und die Rückleitungsabschnitte (D2+, D2-) angeschlossen sind.

8. Kommunikationsbus nach irgendeinem der vorhergehenden Ansprüche, **dadurch gekennzeichnet, dass** die Abzweigleitungen (d+, d-) rechtwinklig zu den Kommunikationsleitungen (D+, D-) angeordnet sind.

9. Kommunikationsbus nach Anspruch 8, **dadurch gekennzeichnet, dass** er an einem Ende der Leiterplatte Anschlussmittel (14) aufweist, die dazu dienen, den genannten Bus mit einem angrenzenden zweiten Kommunikationsbus zu verbinden.

10. Kommunikationsbus nach Anspruch 9, **dadurch gekennzeichnet, dass** die Verbindungsmittel (14) dazu ausgelegt sind, die Kommunikationsleitungen (D+, D-) eines ersten und eines zweiten Busses so miteinander zu verbinden, dass die genannten Leitungen zu einer Wicklung geformt werden, wobei der Wicklungsschritt der Kommunikationsleitungen (D+, D-) annähernd der Länge der Leiterplatte eines Kommunikationsbusses entspricht.

11. Kommunikationsbus nach irgendeinem der vorhergehenden Ansprüche, **dadurch gekennzeichnet, dass** die Leiterplatte auf der gesamten Länge des Kommunikationsbusses bzw. der miteinander verbundenen Kommunikationsbusse von einer Metallschirmung umgeben ist

12. Kommunikationsbus nach Anspruch 11, **dadurch gekennzeichnet, dass** die Metallschirmung elektrisch mit dem Masseleiter (DM) der Leiterplatte verbunden ist und Befestigungsmittel umfasst, die dazu dienen, die Schirmung mechanisch an einer elektrischen Schaltanlage zu befestigen und elektrisch mit dem Masseanschluss der elektrischen Schaltanlage zu verbinden.

13. Kommunikationsbus nach irgendeinem der vorhergehenden Ansprüche, **dadurch gekennzeichnet, dass** sein charakteristischer Wellenwiderstand (Z0) zwischen 100 und 150 Ω beträgt.

14. Kommunikationsbus nach irgendeinem der vorhergehenden Ansprüche, **dadurch gekennzeichnet, dass** der Rasterabstand (p) zwischen zwei Abzweigen (5) kleiner oder gleich 50 Millimeter ist.

15. Kommunikationsbus nach irgendeinem der vorhergehenden Ansprüche, **dadurch gekennzeichnet, dass** die zweiten Enden der Abzweigleitungen (d+, d-) mit dem Rand der Leiterplatte die Kontaktflächen zur Aufnahme von elektrischen Steckverbindern der Kommunikationseinrichtungen (1) bilden.

16. Kommunikationsbus nach irgendeinem der vorhergehenden Ansprüche, **dadurch gekennzeichnet, dass** die Kommunikationsleitungen (D+, D-) nicht geradlinig ausgeführt sind und örtliche Ausformungen aufweisen, die längs der genannten Leitungen ausgebildet sind.

17. Kommunikationsbus nach Anspruch 16, **dadurch gekennzeichnet, dass** die örtlichen Ausformungen als Schlingen (15) mit mindestens zwei geradlinigen Leiterabschnitten (15a, 15b, 15c) ausgebildet sind.

18. Kommunikationsbus nach irgendeinem der vorhergehenden Ansprüche, **dadurch gekennzeichnet, dass** die Kommunikationsleitungen (D+, D-) jeweils mindestens eine Anschlussbuchse umfassen, die zur seriellen Verbindung mit einem Abschnitt eines geschirmten Kabels dient, das eine oder mehrere verdrillte Zweidrahtleitungen enthält.

19. Elektrische Schaltanlage mit Befestigungsmitteln zur Halterung von Befestigungsschienen (3) oder Befestigungsplatten für Kommunikationseinrichtungen (1), welche Befestigungsmittel in einem bestimmten Rastermaß gleichmäßig über die Höhe der genannten Schaltanlage verteilt angeordnet sind, **dadurch gekennzeichnet, dass** die Schaltanlage mindestens einen Kommunikationsbus (10) nach einem der vorhergehenden Ansprüche umfasst, wobei die Abzweige (5) des Kommunikationsbusses (10) in einem bestimmten Rastermaß gleichmäßig angeordnet sind, das einem Vielfachen des Rastermaßes der Schaltanlage entspricht.

20. Elektrische Schaltanlage nach Anspruch 19, **dadurch gekennzeichnet, dass** die Abzweige (5) des Kommunikationsbusses (10) in einem bestimmen Rastermaß gleichmäßig angeordnet sind, das annähernd dem Grundrastermaß der Schaltanlage entspricht.

21. Elektrische Schaltanlage nach Anspruch 20, **dadurch gekennzeichnet, dass** der Kommunikationsbus (10) so angeordnet ist, dass jede Befestigungsschiene oder -platte einem Abzweig (5) gegenüberliegt.
